# EUROPÄISCHE PATENTSCHRIFT

(11) **EP 0 921 594 B1**
(45) Veröffentlichungstag und Bekanntmachung des Hinweises auf die Patenterteilung: **18.12.2002**
(21) Anmeldenummer: 98118784.2
(22) Anmeldetag: 05.10.1998
(51) Int. Cl.: H01R 12/04, H01R 12/32, H05K 1/11, H05K 3/32

(54) **Steckverbindungseinrichtung**
Connection device
Dispositif de connexion

(30) Priorität: 02.12.1997 DE 29721298 U
(43) Veröffentlichungstag der Anmeldung: 09.06.1999
(73) Patentinhaber: FESTO AG & Co, 73734 Esslingen (DE)
(72) Erfinder: Böck, Jürgen, 71706 Markgröningen (DE); Rühle, Peter, 71384 Weinstadt/Schnait (DE); Franz, Jochen, 72762 Reutlingen (DE); Suchy, Walter, 70176 Stuttgart (DE)
(74) Vertreter: Abel, Martin, Dipl.-Ing.

(56) Entgegenhaltungen:
- EP-A- 0 498 952
- DE-A- 3 610 978
- DE-A- 19 539 584
- US-A- 3 284 604

## Beschreibung

Die Erfindung betrifft eine Steckverbindungseinrichtung, mit einem Grundkörper, der wenigstens eine Verbindungseinheit aufweist, die über eine seitlich von einem längsseitigen Randbereich eines länglichen, querelastischen Klemmstegs begrenzte Durchbrechung verfügt, die eine Steckaufnahme bildet, in die ein zum Beispiel stift- oder zungenartiges Steckelement derart einsteckbar ist, daß es von dem Klemmsteg beaufschlagt wird.

Aus der DE 36 10 978 C2 geht eine im Zusammenhang mit einer Leiterplatte konzipierte Steckverbindungseinrichtung hervor, die eine elektrisch leitend kontaktierende Steckverbindung zwischen Leitern der Leiterplatte und Steckelementen eines einem Ventil zugeordneten Elektromagneten ermöglicht. Die Leiterplatte hat eine der Anzahl der Steckelemente entsprechende Anzahl von Durchbrechungen,
die als Steckaufnahmen dienen, in die die Steckelemente einsteckbar sind. Ein Vorteil dieser Ausgestaltung besteht darin, daß auf eine Bestückung der Leiterplatte mit geeigneten Steckbuchsen verzichtet werden kann. Allerdings bedarf es innerhalb der Steckaufnahme aufwendiger Maßnahmen, beispielsweise des Einbringens einer z.B. elektrisch leitfähigen Elastomermasse, um eine die gewünschte Kontaktierung hervorrufende Klemmkraft zwischen der Steckaufnahme und dem zugeordneten Steckelement herbeizuführen.

Man hat daher bereits bei einer der Anmelderin bekannten Steckverbindungseinrichtung der eingangs genannten Art vorgeschlagen, die eine längsseitige Begrenzung der Steckaufnahmen als länglichen, querelastischen Klemmsteg auszubilden. Die zwischen dem Klemmsteg und dem diesem gegenüberliegenden Längsrand der Steckaufnahme definierte Einsteckbreite wird etwas geringer als die Breite des einzusteckenden Steckelementes gewählt, so daß der Klemmsteg beim Einstecken des Steckelementes in Querrichtung rückfedernd elastisch ausgelenkt wird und mit seiner Rückstellkraft das Steckelement mit einer eine sichere Kontaktierung gewährleistenden Klemmkraft beaufschlägt.

Als nachteilig hat sich jedoch bei der bekannten Steckverbindungseinrichtung erwiesen, daß der zwischen der Steckaufnahme und einer weiteren Durchbrechung verlaufende Klemmsteg bei ungünstigen Toleranzpaarungen oder unsachgemäßer Handhabung der Steckverbindungseinrichtung zu Überdehnungen neigt, woraus bleibende plastische Verformungen resultieren, die eine Verringerung der Klemmkraft herbeiführen. Auf diese Weise ist eine sichere mechanische Verbindung zwischen den zusammengesteckten Teilen nicht mehr gewährleistet. In Fällen, in denen die Steckverbindungseinrichtung zur Herstellung einer elektrisch leitenden Verbindung eingesetzt wird, können überdies Kontaktierungsprobleme auftreten.

Es ist die Aufgabe der vorliegenden Erfindung, eine Steckverbindungseinrichtung der eingangs genannten Art zu schaffen, die eine dauerhaft sichere mechanische und bei Bedarf auch elektrisch leitende Verbindung ineinander einzusteckender Bauteile ermöglicht.

Zur Lösung dieser Aufgabe ist vorgesehen, daß der Klemmsteg zu seinen beiden Enden hin verbreitert ausgebildet ist, indem sein von der Steckaufnahme abgewandter längsseitiger Randbereich einen zumindest im wesentlichen bogenartigen Verlauf im Sinne einer Konkavität des Klemmsteges aufweist.

Während beim Stand der Technik der Klemmsteg über Endbereiche konstanten Querschnittes an den benachbarten Grundkörperpartien aufgehängt ist, ergibt sich bei der erfindungsgemäßen Ausgestaltung eine zu den Aufhängungsstellen hin allmähliche Verbreiterung des Klemmsteges, was maßgeblich durch die konkave, im wesentlichen einer Bogenlinie folgende Gestaltung des der Steckaufnahme abgewandten Randbereiches des Klemmsteges erzielt wird. Somit ergibt sich zu den beiden Enden hin eine Zunahme des Querschnittes des Klemmsteges und damit verbunden eine höhere Belastbarkeit im elastisch rückfedernden Bereich. Auch bei ungünstigen Toleranzpaarungen zwischen Steckaufnahme und Steckelement wird eine ausreichend hohe Klemmkraft gewährleistet, die eine sichere mechanische Klemmverbindung zwischen der Steckaufnahme und dem Steckelement hervorruft. Gleichzeitig kann eine sichere elektrische Kontaktierung gewährleistet werden, falls die Steckverbindungseinrichtung auch zur Herstellung einer elektrisch leitenden Steckverbindung herangezogen werden soll. Insgesamt wird mit der erfindungsgemäßen Steckverbindungseinrichtung auch noch nach langer Zeit eine hohe Klemmkraft aufrechterhalten.

Vorteilhafte Weiterbildungen der Erfindung gehen aus den Unteransprüchen hervor.

Um durch die erzielte Klemmkraft eine hohe Flächenpressung zwischen den ineinander eingesteckten Teilen zu erzielen, kann der der Steckaufnahme zugewandte längsseitige Randbereich des Klemmsteges insbesondere etwa mittig wenigstens eine in die Steckaufnahme vorspringende Erhebung aufweisen, deren in Längsrichtung der Steckaufnahme gemessene Länge geringer ist als die in gleicher Richtung gemessene Abmessung des eingesteckten Steckelementes. Die vorgenannte Maßnahme ermöglicht ferner die Realisierung verhältnismäßig schmaler Klemmbreiten innerhalb einer ansonsten eine größere Breite aufweisenden und dadurch eine vereinfachte Herstellung ermöglichenden Steckaufnahme. Beispielsweise kann die Steckaufnahme mit einem Fräser aus dem Grundkörper herausgearbeitet sein.

Die Steckaufnahme kann derart an einem Grundkörper plaziert sein, daß der Klemmsteg einen äußeren Randabschnitt des Grundkörpers bildet. Bei einer anderen bevorzugten Ausgestaltung, die eine beliebige Plazierung innerhalb der Grundfläche des Grundkörpers ermöglicht, ist der Steckaufnahme benachbart eine weitere Durchbrechung vorgesehen, die einen Verformungsfreiraum für den Klemmsteg definiert, wobei der Klemmsteg als Unterteilungselement zwischen den beiden Durchbrechungen verläuft. Beim Einstecken eines Steckelementes in die Steckaufnahme, was beispielsweise auch durch Aufstecken des Grundkörpers auf ein entsprechendes Steckelement erfolgen kann, wird der Klemmsteg geringfügig in Richtung zur weiteren Durchbrechung verformt, wobei diese weitere Durchbrechung einen ausreichenden Verformungsfreiraum zur Verfügung stellt.

In bevorzugter Ausgestaltung ist die der Steckaufnahme benachbarte weitere Durchbrechung in Form eines bogenförmigen Schlitzes mit durchgehend insbesondere konstanter Breite ausgebildet. Eine derartige Formgebung läßt sich sehr einfach zum Beispiel durch einen Fräsvorgang erzielen.

Obgleich die Formgebung des Grundkörpers im Prinzip beliebig ist, erweist sich doch eine plattenartige Ausgestaltung als besonders vorteilhaft. Soll mit der Steckverbindungseinrichtung eine elektrisch leitende Verbindung erreicht werden, kann der Grundkörper insbesondere als Leiterplatte ausgeführt sein, die einen oder mehrere in beliebiger Weise ausgestattete elektrische Leiter trägt. Die elektrischen Leiter sind insbesondere, jedoch nicht zwingend, als Leiterbahnen vorgesehen. Auch sonstige elektrische und/oder elektronische Bauteile können an dem Grundkörper vorgesehen sein.

Nachfolgend wird die Erfindung anhand der beiliegenden Zeichnung näher erläutert. In dieser zeigen:
- Fig. 1: eine erste Bauform der erfindungsgemäßen Steckverbindungseinrichtung in Zusammenhang mit einer Verbindung zwischen einer Leiterplatte und einem zur Betätigung eines Ventils verwendeten Elektromagneten in einer Draufsicht auf die eine Plattenfläche der Leiterplatte mit Blick gemäß Pfeil I aus Fig. 2,
- Fig. 2: einen Längsschnitt durch die Anordnung aus Fig. 1 gemäß Schnittlinie II-II und
- Fig. 3: den in Fig. 1 markierten Ausschnitt III in vergrößerter Darstellung.

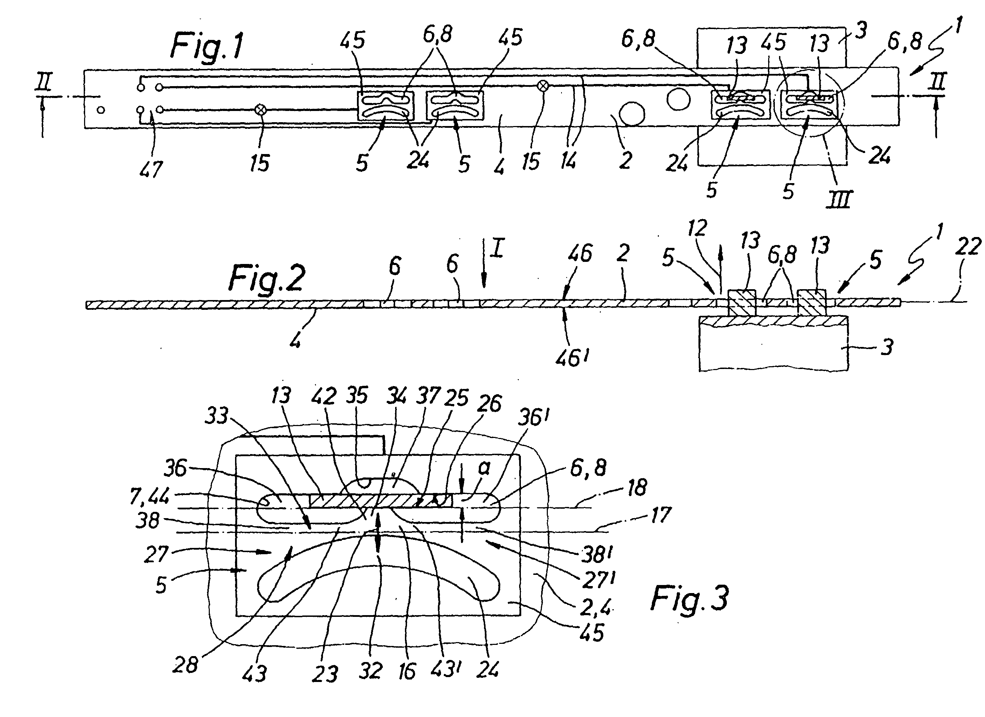

Die Figur 1 zeigt eine allgemein mit 1 bezeichnete Steckverbindungseinrichtung, die im Zusammenhang mit einer Leiterplatte 2 realisiert ist. Sie ermöglicht die Herstellung einer mechanischen und gleichzeitig elektrisch leitenden Verbindung zwischen der Leiterplatte 2 und einem elektrischen Bauteil 3, das beim Ausführungsbeispiel von einem einem nicht näher dargestellten Ventil zugeordneten Elektromagneten gebildet ist.

Die Steckverbindungseinrichtung 1 umfaßt einen zweckmäßigerweise plattenartig ausgebildeten und vorliegend die Leiterplatte 2 repräsentierenden plattenartigen Grundkörper 4, an dem mindestens eine Verbindungseinheit 5 vorgesehen ist. In aller Regel wird der Grundkörper 4 entsprechend der Abbildung über mehrere solche Verbindungseinheiten 5 verfügen, wobei das Ausführungsbeispiel mit vier Verbindungseinheiten 5 ausgestattet ist. Eine der Verbindungseinheiten 5 ist in Fig. 3 vergrößert dargestellt.

Jede Verbindungseinheit 5 verfügt über eine längliche erste Durchbrechung 6, die den Grundkörper 4 rechtwinkelig zu seiner Plattenebene durchsetzt und eine schlitzartige Gestalt hat, wobei sie von einer umlaufenden Begrenzungsfläche 7 eingefaßt ist.

Die erste Durchbrechung 6 bildet eine Steckaufnahme 8, die dazu dient, ein quer zur Plattenebene gemäß Pfeil 12 in sie eingestecktes Steckelement 13 aufzunehmen. Die Aufnahme geschieht in der Regel dergestalt, daß das betreffende Steckelement 13 durch die Steckaufnahme 8 hindurchragt und somit an einem Teilabschnitt seiner Länge von der Steckaufnahme 8 umschlossen ist.

Das Steckelement 13 ist ein dem elektrischen Bauteil 3 vorgesehen und ragt vorsprungartig von diesem elektrischen Bauteil 3 weg. Das Steckelement 13 kann beispielsweise stiftartig oder, wie beim Ausführungsbeispiel, zungenartig ausgeführt sein. Je nach Ausgestaltung des elektrischen Bauteils 3 können an diesem gleichzeitig ein oder mehrere Steckelemente 13 vorgesehen sein, die mit der Leiterplatte 2 in elektrische Steckverbindung gebracht werden sollen. Das elektrische Bauteil 3 des Ausführungsbeispiels verfügt über zwei Steckelemente 13, die bei hergestellter Steckverbindung in die Steckaufnahmen 8 zweier Verbindungseinheiten 5 eingreifen.

Durch die Steckverbindung wird beim Ausführungsbeispiel eine sowohl mechanische als auch elektrisch leitende Verbindung zwischen der Leiterplatte 2 und dem elektrischen Bauteil 3 hergestellt. Auf diese Weise können in dem elektrischen Bauteil 3 verlaufende elektrische Leiter und/oder Bauteile (nicht dargestellt) mit elektrischen Leitern 14 und/oder elektrischen bzw. elektronischen Bauteilen 15 der Leiterplatte 2 elektrisch verbunden werden.

Allerdings läßt sich bei entsprechender Ausgestaltung der Steckverbindungseinrichtung auch eine rein mechanische Verbindung herstellen, um beispielsweise einen beliebigen Grundkörper und ein beliebiges anderes Bauteil durch Zusammenstecken mechanisch aneinander zu fixieren.

Eine der beiden längsseitigen Begrenzungen der länglichen Steckaufnahme 8 ist von einem länglichen, querelastischen Klemmsteg 16 gebildet. Dessen Längsachse 17 verläuft parallel zur Längsachse 18 der Steckaufnahme 8. Er ist quer zu seiner Längsachse 17 in der vorliegend mit der Plattenebene zusammenfallenden Ausdehnungsebene 22 des Grundkörpers 4 elastisch reversibel verformbar, was durch Doppelpfeil 23 angedeutet ist.

Gebildet ist der Klemmsteg 16 beim Ausführungsbeispiel dadurch, daß seitlich neben der die Steckaufnahme 8 bildenden ersten Durchbrechung eine weitere zweite Durchbrechung 24 in dem Grundkörper 4 ausgebildet ist. Die beiden Durchbrechungen 6, 24 sind einander längsseits benachbart angeordnet und definieren zwischen sich den Klemmsteg 16. Mit anderen Worten werden die beiden Durchbrechungen 6, 24 durch den Klemmsteg 16 voneinander abgeteilt.

Wird ein Steckelement 13 in eine Steckaufnahme 8 eingesteckt, wird es von Beaufschlagungsflächen 25, 26 beaufschlagt, die von Partien der die Steckaufnahme 8 längsseits begrenzenden Begrenzungsflächenabschnitte gebildet sind.
Der in Fig. 3 markierte lichte Abstand "a" zwischen den einander entgegengesetzten Beaufschlagungsflächen 25, 26 ist derart auf die entsprechend gemessene Dicke des einzusteckenden Steckelements 13 abgestimmt, daß der lichte Abstand "a" vor dem Einstecken etwas geringer ist als die Dicke des Steckelements 13. Wird nun ein Steckelement 13 in Einsteckrichtung 12 in die Steckaufnahme 8 eingesteckt, ergibt sich eine geringfügige Aufweitung der Steckaufnahme 8 in Querrichtung, wobei der Klemmsteg 16 in Richtung zur zweiten Durchbrechung 24 federelastisch verformt wird. Auf Grund der Querelastizität des Klemmsteges 16 und dessen Tendenz, in die Ausgangsstellung zurückzukehren, übt der Klemmsteg 16 mit der an ihm vorgesehenen ersten Beaufschlagungsfläche 25 eine Klemmkraft auf die zugeordnete Seitenfläche des Steckelements 13 aus und drückt dieses gegen die gegenüberliegend angeordneten zweiten Beaufschlagungsflächen 26. Auf diese Weise ist das Steckelement 13 in der Steckaufnahme 8 kraftschlüssig fixiert.

Um zu verhindern, daß die vom Klemmsteg 15 ausgeübte Klemmkraft im Laufe der Zeit nachläßt und um eine hohe Klemmkraft ohne Gefahr einer dauerhaften plastischen Verformung des Klemmsteges 16 zu gewährleisten, ist der Klemmsteg 16 zu seinen beiden in Längsrichtung 17 weisenden Enden 27, 27' hin verbreitert ausgebildet. Es liegt insbesondere eine allmähliche, kontinuierliche Verbreiterung ausgehend von mittleren Bereichen des Klemmsteges 16 vor. Realisiert wird die Verbreiterung vorzugsweise dadurch, daß der von der Steckaufnahme 8 abgewandte und der zweiten Durchbrechung 24 zugewandte längsseitige Randbereich 28 des Klemmsteges 16 - nachfolgend als äußerer Randbereich 28 bezeichnet - einen zumindest im wesentlichen bogenartigen Verlauf im Sinne einer Konkavität des Klemmsteges 16 aufweist. Durch den bogenähnlichen Verlauf erhält der Klemmsteg 16 mithin auf der der zweiten Durchbrechung 24 zugewandten Seite eine konkave Formgebung. Somit ist der Klemmsteg 16 an seinen der größten Belastung ausgesetzten Endbereichen versteift, so daß einer Materialermüdung vorgebeugt wird und hohe Klemmkräfte gewährleistet sind.

Um den gekrümmten äußeren Randbereich 28 möglichst einfach zu realisieren, ist beim Ausführungsbeispiel die zweite Durchbrechung 24 nach Art eines bogenförmigen Schlitzes ausgeführt, dessen beide Endbereiche etwa auf gleicher Höhe mit den Endbereichen der Steckaufnahme 8 liegen und dessen längsmittiger Scheitelbereich 32 etwa auf gleicher Höhe mit der Längsmitte der Steckaufnahme 8 liegt.Die Auswölbung weist zur Steckaufnahme.

Die in der Ausdehnungsebene 22 gemessene Breite der zweiten Durchbrechung 24 hat ein Mindestmaß, das die erforderliche Querbeweglichkeit des Klemmsteges 16 gewährleistet und somit ein ausreichender Verformungsfreiraum für diesen zur Verfügung steht. Beispielsweise kann die zweite Durchbrechung 24 durch mechanische Bearbeitung im Rahmen eines Fräsvorganges eingebracht werden. Gleiches gilt im übrigen auch für die Steckaufnahme 8.

Allerdings kann es schwierig sein, der Steckaufnahme 8 durch Ausfräsen eine derart geringe Breite zu verleihen, daß auch ein verhältnismäßig dünnes Steckelement 13 sicher fixierbar ist. Die beispielsgemäße Steckaufnahme 8 hat daher eine Gestaltung, bei der trotz verhältnismäßig großer Breite ein wunschgemäß geringer lichter Abstand "a" als Klemmabstand zur Verfügung gestellt werden kann. So ist an dem der Steckaufnahme 8 zugewandten längsseitigen Randbereich 33 des Klemmsteges 16 - nachfolgend als innerer Randbereich 33 bezeichnet- etwa längsmittig eine in die Steckaufnahme 8 vorspringende Erhebung 34 vorgesehen, die die erste Beaufschlagungsfläche 25 aufweist. Ihr liegt an der gegenüberliegenden Längsseite der Steckaufnahme 8 eine Vertiefung 35 gegenüber, deren Längserstreckung größer ist als diejenige der Erhebung 34, wobei die sich axial beidseits an die Vertiefung 35 anschließenden Partien der Begrenzungsfläche 7 jeweils eine zweite Beaufschlagungsfläche 26 bilden. Der lichte Abstand "a" zwischen der ersten Beaufschlagungsfläche 25 und der auf der entgegengesetzten Seite liegenden zweiten Beaufschlagungsflächen 26 definiert den Klemmabstand für die Klemmfixierung des eingesteckten Steckelements 13.

Insgesamt ergibt sich somit für die Steckaufnahme 8 eine Gestaltung mit zwei linearen Endbereichen 36, 36', die über einen U-ähnlich geformten mittleren Bogenabschnitt 37 untereinander verbunden sind. Herstellen läßt sich diese Schlitzgestalt beispielsweise durch einen Fräsvorgang, so daß die Steckaufnahme über ihre gesamte Länge hinweg eine zumindest annähernd konstante Breite aufweist.

Der der Steckaufnahme 8 zugewandte innere Randbereich 33 des Klemmsteges 16 verfügt auf Grund der vorerwähnten Gestaltung der Steckaufnahme 3 über zwei endseitige lineare Endabschnitte 38, 38' und einen durch die Erhebung 34 definierten höckerähnlichen Mittelabschnitt 42. Im Bereich dieses Mittelabschnittes 42 ist der Klemmsteg 16 verbreitert, wobei sich beidseits an den Mittelabschnitt 42 ein Bereich geringster Breite 43 anschließt, ausgehend von den sich die Breite des Klemmsteges 16 zu den Enden 27, 27' hin entsprechend der Krümmung des äußeren Randbereiches 28 kontinuierlich vergrößert.

Da die Steckverbindungseinrichtung 1 des Ausführungsbeispiels zusätzlich zur mechanischen Fixierung auch eine elektrische Kontaktierung bewirken soll, ist die die Steckaufnahme umgrenzende Begrenzungsfläche 7 zumindest partiell von einer elektrisch leitenden Kontaktfläche gebildet. Aus Gründen einer einfachen Herstellung ist beim Ausführungsbeispiel die gesamte Begrenzungsfläche 7 als Kontaktfläche 44 ausgeführt. Hierzu kann der Grundkörper 4 im Bereich der Verbindungseinheiten 5 mit einer zum Beispiel aus Kupfer bestehenden elektrisch leitfähigen Leitschicht 45 versehen sein, die nach der Herstellung der beiden Durchbrechungen 6, 24 aufgebracht wird, so daß eine Durchkontaktierung der Steckaufnahme 8 erfolgt. Zweckmäßigerweise sind auch die Begrenzungsflächen der zweiten Durchbrechung 24 mit einer entsprechenden Leitschicht versehen, wobei man vorsehen kann, daß an beiden einander entgegengesetzten Plattenflächen 46, 46' im Bereich der Verbindungseinheiten 5 eine beschichtete Zone vorliegt.

Die einer jeweiligen Steckaufnahme 8 zugeordnete Leitschicht 45 steht beim Ausführungsbeispiel mit mindestens einem insbesondere als Leiterbahn ausgeführten elektrischen Leiter 14 in Verbindung, der an oder auf dem Grundkörper 4 vorgesehen ist. In den Verlauf der Leiter 14 können bei Bedarf auch schematisch angedeutete elektrische und/oder elektronische Bauteile 15 eingeschaltet sind. Beim Ausführungsbeispiel führen die Leiter 14 zu einer Anschlußstelle 47, an der eine elektrische Kontaktierung mit einem anderen Bauteil möglich ist.

## Patentansprüche

1. Steckverbindungseinrichtung, mit einem Grundkörper (4), der wenigstens eine Verbindungseinheit (5) aufweist, die über eine seitlich von einem längsseitigen Randbereich eines länglichen, querelastischen Klemmstegs (16) begrenzte Durchbrechung (6) verfügt, die eine Steckaufnahme (8) bildet, in die ein zum Beispiel stift- oder zungenartiges Steckelement (13) derart einsteckbar ist, daß es von dem Klemmsteg (16) beaufschlagt wird, **dadurch gekennzeichnet, daß** der Klemmsteg (16) zu seinen beiden Enden hin verbreitert ausgebildet ist, indem sein von der Steckaufnahme (8) abgewandter längsseitiger Randbereich (28) einen zumindest im wesentlichen bogenartigen Verlauf im Sinne einer Konkavität des Klemmsteges (16) aufweist.

2. Steckverbindungseinrichtung nach Anspruch 1, **dadurch gekennzeichnet, daß** die die Steckaufnahme (8) bildende Durchbrechung (6) eine schlitzartige, im wesentlichen längliche Gestalt hat und längsseits von dem Klemmsteg (16) begrenzt ist.

3. Steckverbindungseinrichtung nach Anspruch 1 oder 2, **dadurch gekennzeichnet, daß** der der Steckaufnahme (8) zugewandte längsseitige Randbereich (33) des Klemmsteges (16) zumindest an seinen beiden Endabschnitten (38, 38') im wesentlichen parallel zur Längsachse (18) der Steckaufnahme (8) verläuft.

4. Steckverbindungseinrichtung nach einem der Ansprüche 1 bis 3, **dadurch gekennzeichnet, daß** der der Steckaufnahme (8) zugewandte längsseitige Randbereich (33) des Klemmsteges (16) etwa längsmittig wenigstens eine in die Steckaufnahme (8) vorspringende Erhebung (34) aufweist.

5. Steckverbindungseinrichtung nach Anspruch 4, **dadurch gekennzeichnet, daß** der Erhebung (34) eine an der gegenüberliegenden Längsseite der Steckaufnahme (8) vorgesehene Vertiefung (35) gegenüberliegt.

6. Steckverbindungseinrichtung nach einem der Ansprüche 1 bis 5, **dadurch gekennzeichnet, daß** die Steckaufnahme (8) über ihre Länge hinweg eine zumindest annähernd konstante Breite aufweist.

7. Steckverbindungseinrichtung nach einem der Ansprüche 1 bis 6, **dadurch gekennzeichnet, daß** die Verbindungseinheit (5) eine neben der Steckaufnahme (8) angeordnete weitere Durchbrechung (24) aufweist, die durch den Klemmsteg (16) von der Steckaufnahme (8) abgeteilt ist und einen Verformungsfreiraum für den Klemmsteg (16) zur Verfügung stellt.

8. Steckverbindungseinrichtung nach Anspruch 7, **dadurch gekennzeichnet, daß** die weitere Durchbrechung (24) die Gestalt eines bogenförmigen Schlitzes hat.

9. Steckverbindungseinrichtung nach einem der Ansprüche 1 bis 8, **dadurch gekennzeichnet, daß** der Grundkörper (4) über eine Mehrzahl von Verbindungseinheiten (5) verfügt.

10. Steckverbindungseinrichtung nach einem der Ansprüche 1 bis 9, **dadurch gekennzeichnet, daß** der Grundkörper (4) plattenartig ausgebildet ist und von den vorhandenen Durchbrechungen (6, 24) quer zur Plattenebene durchsetzt wird.

11. Steckverbindungseinrichtung nach Anspruch 10, **dadurch gekennzeichnet, daß** der Grundkörper (4) von einer Leiterplatte (2) gebildet ist.

12. Steckverbindungseinrichtung nach einem der Ansprüche 1 bis 11, **dadurch gekennzeichnet, daß** die die Steckaufnahme (8) umgrenzende Begrenzungsfläche (7) des Grundkörpers (4) zumindest partiell von einer elektrisch leitenden Kontaktfläche (44) gebildet ist, die mit mindestens einem am Grundkörper (4) vorgesehenen elektrischen Leiter (14) in Verbindung steht und zur elektrischen Kontaktierung mit einem eingesteckten, elektrisch leitenden Steckelement (13) vorgesehen ist.

13. Steckverbindungseinrichtung nach Anspruch 12, **dadurch gekennzeichnet, daß** die Kontaktfläche (44) von einer auf den Grundkörper (4) aufgebrachten Leitschicht (45) gebildet ist.

14. Steckverbindungseinrichtung nach einem der Ansprüche 1 bis 13, **dadurch gekennzeichnet, daß** das Steckelement (13) von einem elektrischen Anschlußkontakt eines einem Ventil zugeordneten Elektromagneten oder eines sonstigen elektrischen Bauteils (3) gebildet ist.

## Claims

1. Plug connector device with a base body (4), having one or more connection units (5), which has an opening (6) bounded at the side by a long-side edge zone of an elongated, transversely elastic clamping web (16) and which forms a plug-in location (8) into which a plug element (13), for example pin- or tongue-shaped, may be inserted in such a way that it is under pressure from the clamping web (16), **characterised in that** the clamping web (16) widens out towards its two ends, while its long-side edge zone (28) facing away from the plug-in location (8) has a curved shape, at least substantially, in the sense of a concavity of the clamping web (16).

2. Plug connector device according to claim 1, **characterised in that** the opening (6) forming the plug-in location (8) has a slot-like, substantially elongated shape and is bounded on the long side by the clamping web (16).

3. Plug connector device according to claim 1 or 2, **characterised in that** the long-side edge zone (33) of the clamping web (16) facing the plug-in location (8) runs substantially parallel to the longitudinal axis (18) of the plug-in location (8), at least at its two end sections (38, 38').

4. Plug connector device according to any of claims 1 to 3, **characterised in that** the long-side edge zone (33) of the clamping web (16) facing the plug-in location (8) has one or more elevations (34) extending into the plug-in location (8) in roughly the longitudinal centre.

5. Plug connector device according to claim 4, **characterised in that** a recess (35) provided on the opposite long side of the plug-in location (8) lies opposite the elevation (34).

6. Plug connector device according to any of claims 1 to 5, **characterised in that** the width of the plug-in location (8) is at least approximately constant throughout its length.

7. Plug connector device according to any of claims 1 to 6, **characterised in that** the connection unit (5) has an additional opening (24) located alongside the plug-in location (8) and separated from the plug-in location (8) by the clamping web (16), which provides a deformation space for the clamping web (16).

8. Plug connector device according to claim 7, **characterised in that** the additional opening (24) has the shape of a curved slot.

9. Plug connector device according to any of claims 1 to 8, **characterised in that** the base body (4) has a multiplicity of connection units (5).

10. Plug connector device according to any of claims 1 to 9, **characterised in that** the base body (4) is board-like and is penetrated by the existing openings (6, 24) at right-angles to the plane of the board.

11. Plug connector device according to claim 10, **characterised in that** the base body (4) is formed by a painted circuit board (2).

12. Plug connector device according to any of claims 1 to 11, **characterised in that** the boundary face (7) of the base body (4) bordering the plug-in location (8) is formed at least partially by an electrically conductive contact surface (44) which is connected to one or more electrically conductive conductors (14) provided on the base body (4), and is provided with an inserted electrically conductive plug element (13) for electrically conductive contacting.

13. Plug connector device according to claim 12, **characterised in that** the contact surface (44) is formed by a conducting layer (45) applied to the base body (4).

14. Plug connector device according to any of claims 1 to 13, **characterised in that** the plug element (13) is formed by an electrical connection contact of an electromagnet assigned to a valve or another electrical component (3).

## Revendications

1. Dispositif de liaison par enfichage avec un corps de base (4), qui comporte au moins une unité de liaison (5), laquelle dispose d'un ajour (6) limité latéralement par une zone de bordure, côté longitudinal, d'une nervure de serrage (16) allongée et élastique transversalement, lequel ajour forme un logement d'enfichage (8) dans lequel peut être enfiché un élément d'enfichage (13), par exemple de type broche ou languette, de manière qu'il soit soumis à l'action de la nervure de serrage (16), **caractérisé en ce que** la nervure de serrage (16) est réalisée élargie vers ses deux extrémités, par le fait que sa zone de bordure (28) côté longitudinal, tournée à l'opposé du logement d'enfichage (8), présente un parcours au moins sensiblement du type arc dans le sens d'une concavité de la nervure de serrage (16).

2. Dispositif de liaison par enfichage selon la revendication 1, **caractérisé en ce que** l'ajour (6) qui forme le logement d'enfichage (8) a une forme de type fente, sensiblement allongée et est limité longitudinalement par la nervure de serrage (16).

3. Dispositif de liaison par enfichage selon la revendication 1 ou 2, **caractérisé en ce que** la zone de bordure (33) côté longitudinal, tournée vers le logement d'enfichage (8), de la nervure de serrage (16), s'étend, au moins sur ses deux tronçons terminaux (38, 38'), sensiblement parallèlement à l'axe longitudinal (18) du logement d'enfichage (8).

4. Dispositif de liaison par enfichage selon l'une des revendications 1 à 3, **caractérisé en ce que** la zone de bordure (33) côté longitudinal, tournée vers le logement d'enfichage (8), de la nervure de serrage (16), présente approximativement au milieu de sa longueur au moins un relief (34) qui fait saillie dans le logement d'enfichage (8).

5. Dispositif de liaison par enfichage selon la revendication 4, **caractérisé en ce qu'**au relief (34) fait face un renfoncement (35) prévu sur le côté longitudinal opposé du logement d'enfichage (8).

6. Dispositif de liaison par enfichage selon l'une des revendications 1 à 5, **caractérisé en ce que** le logement d'enfichage (8) présente, sur toute sa longueur, une largeur au moins approximativement constante.

7. Dispositif de liaison par enfichage selon l'une des revendications 1 à 6, **caractérisé en ce que** l'unité de liaison (5) présente un autre ajour (24), disposé à côté du logement d'enfichage (8), qui est séparé du logement d'enfichage (8) par la nervure de serrage (16), et qui forme un espace libre de déformation pour la nervure de serrage (16).

8. Dispositif de liaison par enfichage selon la revendication 7, **caractérisé en ce que** l'autre ajour (24) a la forme d'une fente arquée.

9. Dispositif de liaison par enfichage selon l'une des revendications 1 à 8, **caractérisé en ce que** le corps de base (4) dispose d'une pluralité d'unités de liaison (5).

10. Dispositif de liaison par enfichage selon l'une des revendications 1 à 9, **caractérisé en ce que** le corps de base (4) est réalisé à la manière d'une plaque et est traversé par les ajours (6, 24) existants, perpendiculairement au plan de la plaque.

11. Dispositif de liaison par enfichage selon la revendication 10, **caractérisé en ce que** le corps de base (4) est formé par une plaquette à circuits imprimés (2).

12. Dispositif de liaison par enfichage selon l'une des revendications 1 à 11, **caractérisé en ce que** la surface de délimitation (7), délimitant le pourtour du logement d'enfichage (8), du corps de base (4), est formée au moins en partie par une surface de contact (44) électriquement conductrice qui est en liaison avec au moins un conducteur électrique (14), prévu sur le corps de base (4), et qui est prévue pour la mise en contact électrique avec un élément d'enfichage (13) électriquement conducteur, enfiché.

13. Dispositif de liaison par enfichage selon la revendication 12, **caractérisé en ce que** la surface de contact (44) est formée par une couche conductrice (45) appliquée sur le corps de base (4).

14. Dispositif de liaison par enfichage selon l'une des revendications 1 à 13, **caractérisé en ce que** l'élément d'enfichage (13) est formé par un contact de connexion électrique d'un électro-aimant, associé à une soupape, ou d'un autre composant électrique (3).
